# EUROPEAN PATENT SPECIFICATION

(11) **EP 0 427 689 B1**
(45) Date of publication and mention of the grant of the patent: **17.08.1994**
(21) Application number: 90850340.2
(22) Date of filing: 17.10.1990
(51) Int. Cl.: H04Q 11/04

(54) **A method and apparatus for switching data information through a digital selector**
Verfahren und Vorrichtung für Umschaltung von Dateninformation durch einen digitalen Wähler
Méthode et dispositif pour commuter des données par un sélecteur numérique

(30) Priority: 10.11.1989 SE 8903779
(43) Date of publication of application: 15.05.1991
(73) Proprietor: TELEFONAKTIEBOLAGET L M ERICSSON, 126 25 Stockholm (SE)
(72) Inventor: Haulin, Tord Lennart, S-753 24 Uppsala (SE)
(74) Representative: Lövgren, Tage

(56) References cited:
- CA-A- 1 016 635
- US-A- 3 743 788
- US-A- 4 570 258

## Description

### TECHNICAL FIELD

The present invention pertains to a telecommunication system which operates with pulse code modulation and time multiplex, and more particularly relates to a method and apparatus for through-connecting data information in a digital selector or AXE switch.

### PRIOR ART

A known selector memory device includes an input, a number of memory cells, and an output. Data information, distributed on incoming time slots, arrives at the input of the selector memory device and is written into said device in the order in which it arrives. Data read-out from the memory cells to the output is controlled by control information stored in a control memory device connected to the selector memory device. Data information is written into a memory cell and data information is read-out from a memory cell during the time interval of one time slot. In the case of known techniques, the time interval of one time slot thus comprises a write phase and a read phase. This state of the art may be formed in US-A- 3 743 788.

### DISCLOSURE OF THE INVENTION

In present day techniques, selector memory devices are used in various types of digital selectors. For instance, the selector core of a blocking-free selector of the T-S-type (Time-Space) is constructed of a number of selector memory devices which functionally form a matrix. The memory devices are connected to I/O-devices (IN/OUT), each of which connects an incoming and an outgoing line to the selector core. Each I/O-device handles a plurality of data channels. Data information is written into the selector memory devices in rows in the matrix, whereas data information is read from the matrix in columns.

When such a selector is extended or enlarged upon, the number of selector memory devices required is squared, whereas the number of control memory devices increases linearly with the number of I/O-devices. Consequently, a large number of selector memory devices are required in order to realize a large blocking free T-S-selector or switch which possesses many I/O-devices. This results in problems relating to space and to power.

The inventive method and apparatus solve the aforedescribed problem in that one single inventive selector memory device will effectively replace several known selector memory devices. Thus, several read-outs are effected from the selector memory device during a single time slot interval. Each read-out in a given time slot interval is controlled by a separate control memory device. The inventive selector memory device has an input and data information arriving on said input is distributed on incoming time slots. The incoming data information is written, in a known manner, into the selector memory device during a write-phase of one time slot interval. The selector memory device is conveniently provided with a plurality of outputs, one for each read phase, and during one time slot interval data information is read-out during a number of read phases equal to the number of selector memory outputs. Read out is controlled during each read-out phase by by a control memory device which is individual to said read-out phases. Accordingly, a plurality of control memory devices are connected to the selector memory device, such that each of the control memory devices will correspond to a selector memory output and a read phase. During the read phases in a time slot interval, data information is read to each of the outputs in sequence, wherein read-out from each read phase is controlled by a corresponding control memory device.

Thus, according to the present invention a write-in operation and several read-out operations are carried out in the selector memory device during a time interval corresponding to an incoming time slot, thereby enabling an inventive selector memory device to replace a plurality of known selector memory devices. The advantages afforded by the use of the inventive selector memory device are found primarily in the use of large selector cores, since large space savings are made and power developments are low when the inventive selector memory device is used instead of known selector memory devices. For instance, when using selector memory devices which have four read phases for each write phase, the number of selector memory devices is lowered by a factor of four, in comparison with the use of known selector memory devices.

### BRIEF DESCRIPTION OF THE DRAWINGS

The method and apparatus according to the invention will now be described in more detail with reference to the drawings, in which
Figure 1 illustrates a selector memory device of known technique;
Figure 2 illustrates the manner of arrangement of a known selector memory device in the selector core of a selector of T-S-type;
Figure 3 illustrates an inventive selector memory device; and
Figure 4 illustrates the inventive selector memory device arranged in the selector core of a selector of T-S-type.

### BEST MODE FOR CARRYING OUT THE INVENTION

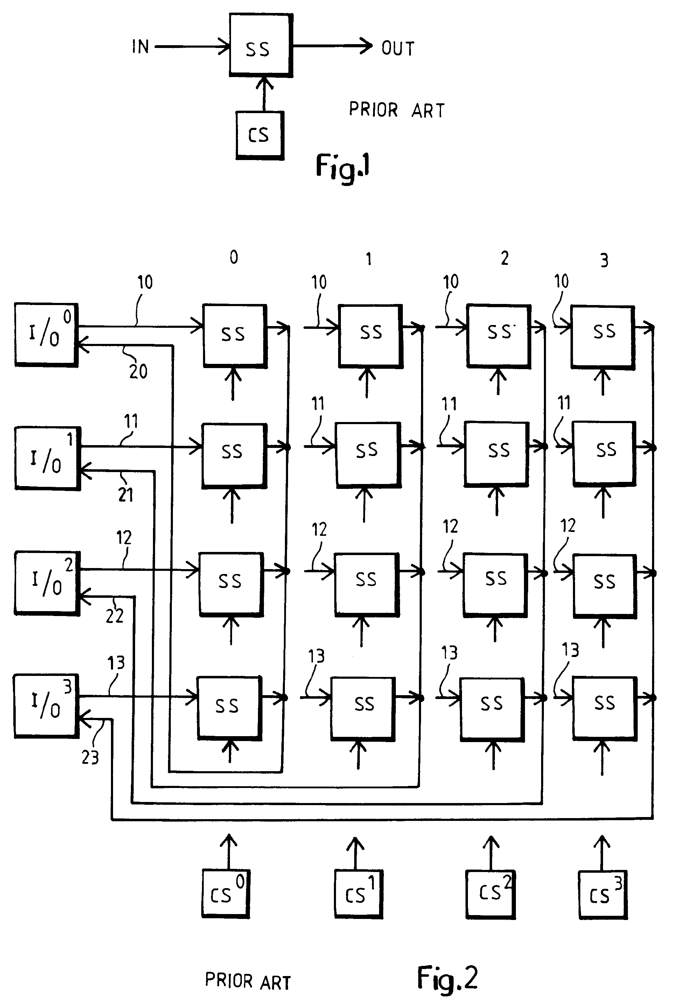

Figure 1 illustrates a selector memory device SS of known kind. Data information, distributed on incoming time slots, enters the selector memory device SS on its input IN. A number of incoming time slots form a frame. The incoming data information is written, for each frame, cyclicly into the selector memory device SS, wherein the information in a given incoming time slot is written into a memory cell with an address which corresponds to the number of the slot.

The data information written into the selector memory device SS is read out to an output OUT under the control of control information stored in a control memory device CS connected to the selector memory device SS. The data information read-out from the device SS is distributed on outgoing time slots. When reading information from the device SS, the control information contained in the control memory device CS is read cyclicly, an address of a memory cell in the control memory device CS corresponding to the number of the outgoing time slot. In the case of known techniques, the time interval of a time slot thus comprises partly a write phase and partly a read phase.

Selector memory devices of the aforedescribed kind are used in the digital selectors for coupling information from an incoming time slot to any predetermined, outgoing time slot whatsoever. For instance, these known selector memory devices are used in non-restricted digital selectors of the type T-S (Time-Space). The selector core of one such known selector is illustrated in Figure 2. The selector core according to the illustrated example includes sixteen selector memory devices SS which functionally form a matrix, and four I/O-devices each of which connects an incoming line 10, ... 13 and an outgoing line 20,...23 to the selector memory devices. Data information is read into the selector memory devices SS in rows, whereas information is read from the said devices in columns.

Data information is written into the selector memory devices SS during the write phase of a time slot interval, the same data information being simultaneously written into all of the selector memory devices belonging to the same row in the matrix. During the read phase of a time slot interval, data information is read from one of the selector memory devices in each column. Read-out is controlled by control information contained in a control memory device CS belonging to each column. The control information controls, for each outgoing time slot, that selector memory device in the column which pertains to the read-out and also that memory cell in the selector memory device concerned from which the information shall be read-out. Control memory device CS number 0 controls the read-out from column number 0 to I/O-device number 0, via outgoing line number 20, control memory device CS number 1 controls the read-out from column number 1 to I/O-device number 1, via outgoing line number 21, and so on.

The fact that data information in a selector memory device is switched from an incoming time slot to some other outgoing time slot endows the selector core with its time selection property (T-step). The selector core obtains its space selection property (S-step) due to the fact that a choice of the selector memory device concerned takes place, when reading data information from one column in the selector memory device.

When the aforedescribed T-S-selector is extended with additional I/O-devices with associated lines, in order to handle additional data channels, the number of selector memory devices SS of known kind will increase considerably, since the number of selector memory devices is equal to the square of the number of I/O-devices. For instance, when the number of I/O-devices is increased to eight, the number of selector memory devices increases to sixty-four. The number of control memory devices CS is equal to the number of I/O-devices, and therewith also increases to eight.

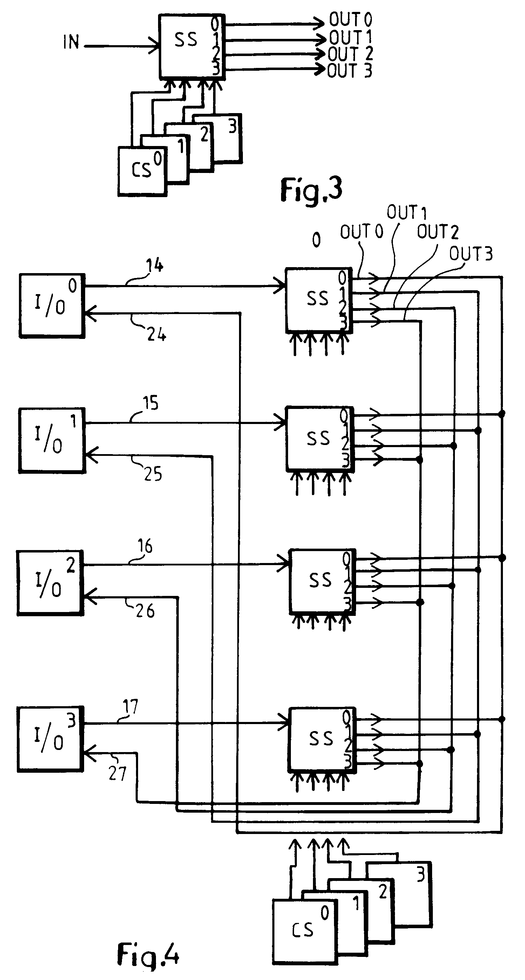

The problem represented by this dramatic increase of the number of selector memory devices with the number of I/O-devices is solved by the present invention in that, in accordance with the principles of the invention, one single selector memory device essentially replaces effectively several selector memory devices of known kind. Figure 3 illustrates an inventive selector memory device SS. Data information entering the selector memory device SS is distributed on incoming time slots. The data information enters on an input IN. The in-coming data information is written-in cyclicly, in the same manner as data is written into the earlier known selector memory device described above. The write-in of information takes place during a write phase of a time slot interval, as earlier described.

The inventive selector memory device is equipped with a plurality of outputs OUT0,...OUT3, according to the illustrated embodiment four outputs. Connected to the selector memory device SS are an equal number of control memory devices CSO,... CS3 corresponding to respective outputs. The control memory devices contain control information for controlling the read-out of data information from the selector memory device. In the illustrated example, the outputs and control memory devices are numbered from 0 to 3. Each of the control memory devices is connected to a corresponding output for read-out purposes. With read-out to output number 0 OUT0, control memory device number 0 CS0 is connected to control the read-out. In the case of read-out to output number 1 OUT1, the control memory device number 1 CS1 is connected to control the read-out, and so on. In order to enable one single selector memory device according to the invention to replace several selector memory devices of known kind, several read-outs are effected sequentially, each to a respective output, during a time slot interval corresponding to an incoming time slot. Read-out takes place during a read phase. In the case of the illustrated example, one time slot interval includes four read phases, data information being read-out to the output OUT number 0 during the first read phase under the control of control information stored in the control memory device CS number 0, data information being read to the output number 1 during the second read phase of the time slot interval, under the control of control information contained in the control memory device CS number 1 and so on. During a read phase, the actual read-out is controlled in the same manner as in known techniques. During the first read phase of a time slot interval, for instance number 7, the control information in the control memory device number 0, memory cell number 7, controls which memory cell of the selector memory device data information can be read from. Thus, the control information contains the address in the selector memory device from which data information can be read. In the case of the illustrated example, the time interval includes a time slot, thus partly a write phase and partly four read phases. The inventive selector memory therewith replaces effectively four selector memory devices of known kind. Thus, one advantage of using the inventive selector memory device is found in the saving of memory space.

Figure 4 illustrates the selector core of a T-S-selector which is of the same size as the selector core of the Figure 2 embodiment, but which is constructed with selector memory devices according to the invention. The gain obtained in the form of saved memory space when using the inventive selector memory device instead of a known selector memory device is clearly evident when a comparison is made between these two selector cores. In the case of the selector core illustrated in Figure 4, the number of selector memory devices SS has been reduced to four, i.e. to a quarter of the number of selector memory devices required in the Figure 2 embodiment.

As with the earlier described selector core, the selector core of the Figure 4 embodiment includes four I/O-devices. The selector core includes four inventive selector memory devices SS which are arranged in a column, column number 0. Each inventive selector memory device SS replaces a row of known selector memory devices in the earlier described T-S-selector. Data information from the I/O-devices is supplied to the selector memory devices on incoming lines 14, 15, 16, 17, and subsequent to time-slot-switching in the selector memory devices the data information is delivered from the outputs OUT 0, OUT 2, OUT 2, OUT 3 back to the I/O-devices on outgoing data lines 24, 25, 26, 27.

The following takes place in the T-S-selector core illustrated in Figure 4 during a time slot interval corresponding to an incoming time slot, for instance time slot number 7. During the write phase, data information from the I/O-devices is written into memory cell number 7 in corresponding selector memory devices. The time slot interval includes thereafter four read phases. During the first read phase, control information in the memory cell having address number seven in control memory device CS number 0 controls the read-out from one single selector memory device of the column to I/O-device number 0 on the outgoing data line number 24 which is connected to output OUT number 0 on respective selector memory devices SS. The control information partly controls which of the selector memory devices is relevant for read-out and partly controls from which memory cell in the selector memory device concerned read-out shall be effected. During the second read phase of the exemplifying time slot interval, the read out from one of the selector memory devices is control led by control information in control memory device CS number 1. The read out is then effected to I/O-device number 1 on the output line 25 which is connected to output OUT number 1 on respective selector memory devices. Read-out from the selector memory devices takes place in the same manner during the third and fourth read phases, read-out during the third read phase is control led by control memory device number 2 and data information is delivered to I/O-device number 2. The read-out during the fourth read phase is controlled by control information in control memory device CS number 3, data information being delivered to I/O-device number 3. During the read phases of the time slot interval, read-out is thus effected to all I/O-devices, with the read-out to different I/O-devices taking place during separate read phases of the time slot interval.

It is, of course, possible to extend the selector core with more I/O-devices and more selector memory devices. For instance, if the selector core is extended with a further four I/O-devices, the number of selector memory devices increases to sixteen selector memory devices arranged functionally in two columns of eight. Information is written-in rowwise, so that the same data information is written into the two selector memory devices belonging to the same row. Data information is delivered to the selector memory devices from the I/O-device which corresponds to respective rows of selector memory devices. In read-out, data information is read from one of the columns to four of the eight I/O-devices and from the other column to the remaining four I/O-devices. Thus, read-out from each column is effected to four I/O-devices corresponding to said column, since the selector memory devices in respective columns have four outputs and are control led by four control memory devices during four read phases of each time slot interval.

It will be seen that compared with known technique, each individual read-out effected in accordance with the invention will take place more quickly than a read-out from known selector memory devices, since a time slot interval corresponding to an incoming time slot includes four read phases instead of only one, as in the earlier known case. This rapid read-out of information enables the number of selector memory devices required to be reduced when using the inventive selector memory device.

The aforedescribed, exemplifying selector memory device has four read phases for each write phase and is connected to the same number of control memory devices and therewith replaces four selector memory devices of the earlier known kind. It is also possible to construct an inventive selector memory device such that said device will replace a number of known selector memory devices other than four. For instance, the inventive selector memory device can be constructed for two or eight read phases for each write phase and can be connected to a corresponding number of control memory devices. The factor which is capable of limiting the number of control memory devices that can be connected to the selector memory device is found in the shortest possible read-out time, since it must be possible to effect during a time slot interval the same number of read-outs as the number of control memory devices that are connected to a selector memory device.

Although not really preferred, it is conceivable in the case of multiplexer to provide a selector memory device with fewer outputs than the number of read phases and the number of control memory devices connected to the selector memory device. When demultiplexers are connected to the I/O-devices in a selector, it is conceivable for more I/O-devices in time multiplex to share a line or some other data transmission medium from the outputs of the selector memory devices.

## Claims

1. A method for through-connecting data information in a digital selector incorporated in a telecommunication system, said data information arriving at the selector memory device (SS) distributed on time slots and written into the selector memory device (SS) during write phases belonging to the time slots, said written information being read from the selector memory device (SS) with the aid of a control memory device (CS), during read phases belonging to said time slots, **characterized** in that for read-out two or more read phases are arranged for each write phase; and in that the read-out of data information is controlled with the aid of a control memory device (CS) which is individual to each read phase.

2. A method according to Claim 1, **characterized** by four read phases and one write phase for each time slot.

3. A digital selector for through-connecting data information, said selector including a selector memory device (SS) provided with a data input, wherein data information arriving at the data input of said selector memory device (SS) is distributed on time slots, and wherein data information entering said selector memory device (SS) is written-in during write phases belonging to the time slots, and wherein the selector memory device (SS) has connected thereto a control memory device (CS) which contains control information for controlling the read-out of data information from said selector memory device (SS) during read phases, **characterized** in that a plurality of control memory devices (CS) are connected to said selector memory device (SS); in that data information is read from said selector memory device (SS) during several read phases for each write phase; and in that during read-outs, each of the control memory devices (CS) functions to control the read-out of data information from said selector memory device (SS) in sequence during each respective read phase.

4. A digital selector according to Claim 3,
**characterized** in that said selector memory device (SS) has at least two outputs for the read-out of information; and in that at least two control memory devices (CS) are constructed to control the read-out of information to its respective selector memory output in sequence during each respective read phase.

5. A digital selector according to Claim 3,
**characterized** in that a plurality of selector memory devices (SS) are arranged functionally in a matrix; in that, in a known manner, the same data information is written-into different selector memory devices (SS) in one and the same row, whereas different data information is written into different selector memory devices (SS) in one and the same column; and in that the same control memory device (CS) controls the read-out of information from the selector memory devices (SS) in one and the same column during the read phase of said control memory device (CS), whereas different control memory devices (CS) control the read-out of information from the selector memory devices (SS) in different columns and during different read phases.

6. A digital selector according to Claim 5,
**characterized** in that the selector includes said multi-output selector memory devices (SS) arranged in a matrix containing at least one column; in that connected to respective selector memory devices (SS) in each row in the matrix is an incoming line 14, 15, 16, 17 from an I/O-device corresponding to said rows; in that during the write phase of a time slot interval data information from the I/O-devices is written row-wise into the selector memory devices (SS); in that each corresponding output on the selector memory devices (SS) belonging to one and the same column is connected to a respective I/O-device; in that data information is read-out column-wise from the selector memory devices (SS) to the I/O-devices; in that each of the selector memory devices (SS) in each of said columns is connected to a plurality of control memory devices (CS) corresponding to the number of outputs on the selector memory devices (SS) and the read phases for each write phase, said control memory devices (CS) containing control information for controlling the read-out of data information from the selector memory devices (SS) in said columns during a read phase for each control memory device (CS); in that during read-out said control information indicates from which of the selector memory devices (SS) in said column read-out shall occur; in that data information is read-out from respective columns during a plurality of read phases of one time slot interval; in that during respective read phases data information is read-out from one of the selector memory devices (SS) in respective columns to the output which pertains to the read phase concerned under the control of control information contained in the control memory device (CS) corresponding to the read phase and the output.

## Patentansprüche

1. Ein Verfahren zum Durchverbinden von Dateninformation in einem digitalen Wähler, der in einem Telekommunikationssystem eingebaut ist, wobei Dateninformationen an der Wähler-Speichereinrichtung SS auf Zeitschlitzen verteilt ankommen und während Schreibphasen, die zu den Zeitschlitzen gehören, in die Wähler-Speichereinrichtung (SS) geschrieben werden, wobei die eingeschriebenen Informationen unter Zuhilfenahme einer Steuer-Speichereinrichtung (CS) aus der Wähler-Speichereinrichtung (SS) während Lesephasen, die zu den Zeitschlitzen gehören, ausgelesen werden, dadurch **gekennzeichnet**, daß zum Auslesen zwei oder mehrere Lesephasen für jede Schreibphase angeordnet sind; und daß das Auslesen von Dateninformation unter Zuhilfenahme einer Steuer-Speichereinrichtung (CS), die für jede Lesephase individuell vorgesehen ist, gesteuert wird.

2. Ein Verfahren nach Anspruch 1, gekennzeichnet durch vier Lesephasen und eine Schreibphase für jeden Zeitschlitz.

3. Ein digitaler Wähler zum Durchverbinden von Dateninformation, wobei der Wähler eine mit einem Dateneingang versehene Wähler-Speichereinrichtung (SS) umfaßt und wobei an dem Dateneingang der Wähler-Speichereinrichtung (SS) ankommende Dateninformation auf Zeitschlitzen verteilt ist und wobei in die Wähler-Speichereinrichtung (SS) gelangende Dateninformation während Schreibphasen, die zu den Zeitschlitzen gehören, eingeschrieben wird und wobei die Wähler-Speichereinrichtung (SS) eine damit verbundene Steuer-Speichereinrichtung (CS) aufweist, die Steuerinformation zum Steuern des Auslesevorgangs von Dateninformation aus der Wähler-Speichereinrichtung (SS) während Lesephasen enthält,
dadurch **gekennzeichnet**, daß eine Vielzahl von Steuer-Speichereinrichtungen (CS) mit der Wähler-Speichereinrichtung (SS) verbunden sind; daß Dateninformation aus der Wähler-Speichereinrichtung (SS) während mehrerer Lesephasen für jede Schreibphase gelesen wird; und daß während der Auslesevorgänge jede der Steuer-Speichereinrichtungen (CS) arbeitet, um das Auslesen von Dateninformation aus der Wähler-Speichereinrichtung (SS) aufeinanderfolgend während jeder jeweiligen Lesephase zu steuern.

4. Ein digitaler Wähler nach Anspruch 3, dadurch gekennzeichnet, daß die Wähler-Speichereinrichtung (SS) wenigstens zwei Ausgänge für das Auslesen von Information aufweist; und daß wenigstens zwei Steuer-Speichereinrichtungen (CS) aufgebaut sind, um das Auslesen von Information an ihren jeweiligen Wähler-Speicherausgang aufeinanderfolgend während jeder jeweiligen Lesephase zu steuern.

5. Ein digitaler Wähler nach Anspruch 3, dadurch gekennzeichnet, daß eine Vielzahl von Wählern-Speichereinrichtungen (SS) funktionell in einer Matrix angeordnet sind; daß in einer bekannten Weise die gleiche Dateninformation in verschiedene Wähler-Speichereinrichtungen (SS) in ein und dergleichen Zeile eingeschrieben wird, wohingegen verschiedene Dateninformation in verschiedene Wähler-Speichereinrichtungen (SS) in ein und dergleichen Spalte geschrieben wird; und daß die gleiche Steuer-Speichereinrichtung (CS) das Auslesen von Information aus den Wähler-Speichereinrichtungen (SS) in ein und der gleichen Spalte während der Lesephase der Steuer-Speichereinrichtung (CS) steuert, wohingegen verschiedene Steuer-Speichereinrichtungen (CS) das Auslesen von Information aus den Wähler-Speichereinrichtungen (CS) in verschiedenen Spalten und während unterschiedlicher Lesephasen steuern.

6. Ein digitaler Wähler nach Anspruch 5, dadurch gekennzeichnet, daß der Wähler die in einer wenigstens eine Spalte umfassende Matrix angeordneten Wähler-Speichereinrichtungen (SS) mit mehreren Ausgängen umfaßt; daß mit jeweligen Wähler-Speichereinrichtungen (SS) in jeder Zeile in der Matrix eine ankommende Leitung (14, 15, 16, 17) von einer I/O-Einrichtung entsprechend der Zeilen verbunden ist; daß während der Schreibphase eines Zeitschlitzintervalls Dateninformation von den I/O-Einrichtungen zeilenweise in die Wähler-Speichereinrichtungen (SS) geschrieben wird; daß jeder entsprechende Ausgang der zu ein und der gleichen Spalte gehörenden Wähler-Speichereinrichtungen (SS) mit einer jeweiligen I/O-Einrichtung verbunden ist; daß Dateninformation spaltenweise aus den Wähler-Speichereinrichtungen (SS) an die I/O-Einrichtungen ausgelesen wird; daß jede der Wähler-Speichereinrichtungen (SS) in jeder der Spalten mit einer Vielzahl von Steuer-Speichereinrichtungen (CS) entsprechend der Anzahl von Ausgängen auf den Wähler-Speichereinrichtungen (SS) und der Lesephasen für jede Schreibphase verbunden ist, wobei die Steuer-Speichereinrichtungen (CS) Steuerinformation zum Steuern des Auslesevorgangs von Dateninformation aus den Wähler-Speichereinrichtungen (SS) in den Spalten während einer Lesephase für jede Steuer-Speichereinrichtung (CS) enthält; daß während des Auslesevorgangs die Steuerinformation anzeigt, von welcher der Wähler-Speichereinrichtungen (SS) in der Spalte ein Auslesevorgang auftreten soll; daß Dateninformationen von jeweiligen Spalten während einer Vielzahl von Lesephasen eines Zeitschlitzintervalls ausgelesen wird; daß während jeweiliger Lesephasen Dateninformation von einer der Wähler-Speichereinrichtungen (SS) in jeweiligen Spalten an den Ausgang, der sich auf die betreffende Lesephase bezieht, unter der Steuerung von Steuerinformation ausgelesen wird, die in der Steuer-Speichereinrichtung (CS) entsprechend der Lesephase und dem Ausgang enthalten ist.

## Revendications

1. Un procédé pour interconnecter de l'information de données dans un sélecteur numérique qui est incorporé dans un système de télécommunication, cette information numérique arrivant au dispositif de mémoire de sélecteur (SS) en étant répartie dans des créneaux temporels et étant écrite dans le dispositif de mémoire de sélecteur (SS) pendant des phases d'écriture qui appartiennent aux créneaux temporels, l'information écrite étant lue dans le dispositif de mémoire de sélecteur (SS) à l'aide d'un dispositif de mémoire de commande (CS), pendant des phases de lecture qui appartiennent aux créneaux temporels, **caractérisé** en ce que pour effectuer la lecture, deux phases de lecture, ou plus, sont établies pour chaque phase d'écriture; et en ce que la lecture de l'information de données est commandée à l'aide d'un dispositif de mémoire de commande (CS) qui est affecté individuellement à chaque phase de lecture.

2. Un procédé selon la revendication 1, **caractérisé** par quatre phases de lecture et une phase d'écriture pour chaque créneau temporel.

3. Un sélecteur numérique pour interconnecter de l'information de données, ce sélecteur comprenant un dispositif de mémoire de sélecteur (SS) qui comporte une entrée de données, dans lequel de l'information de données qui arrive à l'entrée de données du dispositif de mémoire de sélecteur (SS) est répartie dans des créneaux temporels, et dans lequel de l'information de données qui entre dans le dispositif de mémoire de sélecteur (SS) est écrite pendant des phases d'écriture qui appartiennent aux créneaux temporels, et dans lequel un dispositif de mémoire de commande (CS) est connecté au dispositif de mémoire de sélecteur (SS) et il contient de l'information de commande pour commander la lecture d'information de données dans le dispositif de mémoire de sélecteur (SS) pendant des phases de lecture, **caractérisé** en ce qu'un ensemble de dispositifs de mémoire de commande (CS) sont connectés au dispositif de mémoire de sélecteur (SS); en ce que l'information de données est lue dans le dispositif de mémoire de sélecteur (SS) pendant plusieurs phases de lecture pour chaque phase d'écriture; et en ce que pendant des lectures, chacun des dispositifs de mémoire de commande (CS) commande la lecture d'information de données dans le dispositif de mémoire de sélecteur (SS) en séquence au cours de chaque phase de lecture respective.

4. Un sélecteur numérique selon la revendication 3, **caractérisé** en ce que le dispositif de mémoire de sélecteur (SS) comporte au moins deux sorties pour la lecture d'information; et en ce qu'au moins deux dispositifs de mémoire de commande (CS) sont réalisés de façon à commander la lecture d'information vers la sortie de mémoire de sélecteur respective, en séquence, pendant chaque phase de lecture respective.

5. Un sélecteur numérique selon la revendication 3, **caractérisé** en ce qu'un ensemble de dispositifs de mémoire de sélecteur (SS) sont disposés fonctionnellement en une matrice; en ce que, d'une manière connue, la même information de données est écrite dans différents dispositifs de mémoire de sélecteur (SS) dans une seule et même ligne, tandis que des informations de données différentes sont écrites dans des dispositifs de mémoire de sélecteur (SS) différents dans une seule et même colonne; et en ce que le même dispositif de commande de mémoire (CS) commande la lecture d'information dans les dispositifs de mémoire de sélecteur (SS) dans une seule et même colonne pendant la phase de lecture du dispositif de mémoire de commande (CS), tandis que différents dispositifs de mémoire de commande (CS) commandent la lecture d'information dans les dispositifs de mémoire de sélecteur (SS) dans différentes colonnes et pendant différentes phases de lecture.

6. Un sélecteur numérique selon la revendication 5, **caractérisé** en ce que le sélecteur comprend les dispositifs de mémoire de sélecteur à sorties multiples (SS) disposés en une matrice contenant au moins une colonne; en ce qu'un conducteur entrant (14, 15, 16, 17) est connecté à des dispositifs de mémoire de sélecteur respectifs (SS) dans chaque ligne dans la matrice, ce conducteur entrant provenant d'un dispositif d'entrée/sortie qui correspond aux lignes précitées; en ce que pendant la phase d'écriture d'un intervalle de créneau temporel, de l'information de données provenant des dispositifs d'entrée/sortie est écrite ligne par ligne dans les dispositifs de mémoire de sélecteur (SS); en ce que chaque sortie correspondante des dispositifs de mémoire de sélecteur (SS) appartenant à une seule et même colonne est connectée à un dispositif d'entrée/sortie respectif; en ce que de l'information de données est lue colonne par colonne dans les dispositifs de mémoire de sélecteur (SS) pour être transmise aux dispositifs d'entrée/sortie; en ce que chacun des dispositifs de mémoire de sélecteur (SS) dans chacune des colonnes est connecté à un ensemble de dispositifs de mémoire de commande (CS) correspondant au nombre de sorties des dispositifs de mémoire de sélecteur (SS) et au nombre des phases de lecture pour chaque phase d'écriture, les dispositifs de mémoire de commande (CS) contenant une information de commande pour commander la lecture d'information de données dans les dispositifs de mémoire de sélecteur (SS) dans les colonnes, pendant une phase de lecture, pour chaque dispositif de mémoire de commande (CS); en ce que pendant la lecture, l'information de commande indique dans quel dispositif particulier parmi les dispositifs de mémoire de sélecteur (SS) dans la colonne considérée la lecture doit avoir lieu; en ce que l'information de données est lue dans des colonnes respectives pendant un ensemble de phases de lecture d'un intervalle de créneau temporel; et en ce que pendant des phases de lecture respectives l'information de données est lue dans l'un des dispositifs de mémoire de sélecteur (SS) dans des colonnes respectives, pour être transmise à la sortie qui correspond à la phase de lecture considérée, sous la commande de l'information de commande qui est contenue dans le dispositif de mémoire de commande (CS) correspondant à la phase de lecture et à la sortie.
